(19) Europäisches Patentamt
European Patent Office
Office européen des brevets

(11) **EP 2 479 891 A1**

(12) **EUROPEAN PATENT APPLICATION**

(43) Date of publication:
**25.07.2012 Bulletin 2012/30**

(51) Int Cl.:
***H03H 9/02*** *(2006.01)*

(21) Application number: **11168324.9**

(22) Date of filing: **31.05.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.01.2011 US 434891 P**

(71) Applicant: **IMEC**
**3001 Leuven (BE)**

(72) Inventors:
• **Rottenberg, Xavier**
**1030 Schaarbeek (BE)**

• **Jansen, Roelof**
**3000 Leuven (BE)**
• **Stoffels, Steve**
**3530 Houthalen (BE)**
• **Tilmans, Hendrikus**
**3630 Maasmechelen (BE)**

(74) Representative: **Sarlet, Steven Renaat Irène et al**
**Gevers**
**Intellectual Property House**
**Holidaystraat 5**
**1831 Diegem (BE)**

(54) **MEMS resonator with optimized support anchoring**

(57) MEMS resonator comprising: a substrate; a resonator body (1) suspended above the substrate by means of clamped-clamped beams (4), each beam comprising two support legs (41, 42) with a common connection (5) to the resonator body, the resonator body (1) being adapted for resonating at an operating frequency (fres); excitation means (6, 7) for exciting the resonator body into a vibration at the operating frequency (fres). Each beam is adapted for oscillating in a flexural mode at a given flexural wavelength as a result of said vibration of said resonator body at said operating frequency (fres). Each leg is acoustically long with respect to said flexural wavelength of the beam.

*F i g . 1*

EP 2 479 891 A1

## Description

### Technical field

The present invention relates to a microelectromechanical or nanoelectromechanical resonator structure with optimised support anchoring.

### Background art

Microelectromechanical (MEM) or nanoelectromechanical (NEM) resonators are regarded as a promising choice for timing references to replace for example quartz crystal oscillators in electronic circuits as disclosed by W.-T., Hsu, J. R. Clark, et al., in « Mechanically temperature-compensated flexural-mode micromechanical resonators", Technical Digest International Electron Devices Meeting 2000 (IEDM2000), pp. 399-402, hereby incorporated by reference in its entirety. One of the main drawbacks of these MEMS resonators is frequency stability which can be adversely influenced by temperature drifts and aging. As a result temperature stability is of paramount importance to ensure a precise resonant frequency, on a repeatable and predictable basis. The temperature dependence of the resonance frequency of typical mechanical resonators is typically dominated by the temperature dependence of the Young's modulus of the constitutive material of the resonator.

For Si(Ge)-based MEM resonators, that are quickly gaining traction in microelectronics, this temperature dependence is unfortunately too large (much larger than for quartz crystal resonators) to allow the passive implementation of these resonators in for example handheld applications where the temperature specifications range for example from -40°C to 85°C.

Another important design aspect of a MEMS resonator that needs to be taken into account is the minimization of the acoustic energy loss to the substrate. This mainly depends on the design of the support beams that anchor the MEMS resonator body to the substrate.

Electro-Mechanical stability or rigidity of the MEMS resonator in the direction of the vibration also needs to be considered and is highly dependent on the design of the support anchoring beams that are used to connect the MEMS resonator body to the substrate.

### Disclosure of the invention

It is an aim of this invention to provide a MEMS resonator with improved thermal resistance towards the substrate above which it is suspended, without adversely affecting the electro-mechanical stability of the resonator.

According to the invention, the aforementioned aim is achieved with the MEMS resonator showing the technical characteristics of the first claim.

The MEMS resonator according to the invention comprises: a substrate; a resonator body suspended above the substrate by means of clamped-clamped beams, each beam comprising two support legs with a common connection to the resonator body, the resonator body being adapted for resonating at an operating frequency ($f_{res}$); and excitation means for exciting the resonator body into a vibration at the operating frequency ($f_{res}$).

According to the invention, each beam is adapted for oscillating in a flexural mode at a given flexural wavelength as a result of said vibration of said resonator body at said operating frequency ($f_{res}$). This means that the properties of the beam are selected such that the beam is made to oscillate in the flexural mode (i.e. exhibits a low stiffness for this oscillation) as a result of the targeted vibration of the resonator body. It has been found that the ability of the beam to oscillate in the flexural mode can enhance or at least maintain electro-mechanical stability of the resonator while an understanding of the flexural mode can be used to optimise the beam design for other parameters.

According to the invention, furthermore each leg is acoustically long with respect to said flexural wavelength of the beam vibration, i.e. has a relatively long length with respect to prior art devices, which enhances the thermal insulation of the resonator body. As a result, the resonator of the invention can be heated to an operating temperature to keep the operating frequency substantially stable, without significant heat losses towards the substrate. The common central connection is preferably selected or designed to have a minimum length in view of electro-mechanical stabitily. The minimum length is determined by the design parameters and fabrication process.

In preferred embodiments, each leg has a length ($L_{Tsup,opt}$) equal to a predetermined multiple of said flexural wavelength divided by two, plus a predetermined offset, the predetermined multiple being selected in view of optimising thermal resistance of the leg and the predetermined offset being selected in view of optimising the quality factor of the resonator. By selecting one of these lengths for the support legs, the impedance at the connection point of the resonator and the impedance at the anchors are matched. As a consequence, the loss of energy to the substrate via the anchors can be minimized and a resonator device with optimized Q-factor can be provided.

In preferred embodiments, the predetermined offset is substantially equal to half the length ($L_{cl-cl,1}$) of a clamped-clamped beam with first flexural resonance frequency equal to the operating frequency ($f_{res}$). It has been found that the Q-factor is a periodic function of the support leg length of the resonator and that this predetermined offset substantially corresponds to the maxima of the periodic function.

In preferred embodiments, the resonator body is adapted for resonating in a breathing mode which has a symmetry axis where displacement is minimal and wherein the common connections of the clamped-clamped beams are located at said symmetry axis. This means that the beams are connected to the resonator body at points of minimal displacement, which can enhance the electro-mechanical stability of the resonator.

The high levels of electro-mechanical stability which can be achieved according to the invention further allows large voltages to be applied without the danger of pull-in, thus achieving lower motional impedance of the MEMS resonator which can lead to easier integration.

In preferred embodiments, the clamped-clamped beams are T-shaped, centrally connected to the resonator body. In alternative embodiments, the clamped-clamped beams can also be for example angled beams.

In preferred embodiments, the clamped-clamped beams have a rigid direction, said excitation means being located for exciting the resonator body in the rigid direction of said beams. For example, in the case of T-shaped beams, the rigid direction is the longitudinal direction of the support legs and the beams have a low stiffness in any direction orthogonal thereto.

In preferred embodiments, at least one of said beams forms a heating resistance for heating the resonator through Joules heating. A stable temperature can thus be achieved by controlling the amount of current passing through the clamped-clamped beams. In addition by using the acoustically long legs, the heat transfer from the resonator to carrier wafer and from carrier wafer to the resonator can be minimized. In this way the resonator can be partially shielded from transient temperature changes of the carrier wafer since the heat generated in the clamped-clamped beams or support is preserved to the current location.

Preferred embodiments of the MEMS resonator of the invention as described above can offer a precise resonant frequency, electromechanical stability and a high Q-factor. The invention or its preferred embodiments offer an improved MEMS resonator device, with improved frequency stability control, temperature insulation, electro-mechanical stability and high Q-factor.

### Brief description of the drawings

The invention will be further elucidated by means of the following description and the appended drawings.

Figure 1 presents a general overview of the MEMS resonator device of embodiments according to the invention, comprising a main resonance body of any shape (rectangular, square, circular, parallelepiped, cube, etc), at least one means of actuation (ex electrode, magnetic) and at least one T-shape support for anchoring the main resonator body to the substrate. The T-shaped support or T-support further comprises a clamped-clamped beam attached by means of anchors to the substrate, and a central connection or connection to the main resonant body.
Figure 2 shows the top view of a bar-type bulk acoustic wave (BAW) resonator with "acoustically long" T supports.
Figure 3 shows the SEM image of a SiGe bar-type BAW resonator with acoustically long T-type supports.
Figure 4 describes the design parameters considered in embodiments according to the invention.
Figure 5 shows a representation of the quarter-wave matching transformer.
Figure 6 shows the Smith chart representation of a short-to-open transformation through use of a (2i+1) $\lambda$/4 transmission line section.
Figure 7 shows the SEM image of a resonator with T-type support of an embodiment according to the invention, with the insert showing a closer view of the support itself.
Figure 8 shows the results from FEM simulations.
Figure 9 shows a perspective view of an embodiment of a MEMS resonator according to the invention with Joules heating via the supports and temperature measurement by means of a resistance on top of the resonator body.
Figure 10A-C shows displacement of an oscillating MEMS resonator suitable for use in embodiments according to the invention.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

As used herein, the term resonator encompasses all structures having or capable of having a desired, mechanical or electro-mechanical vibration. In the example that follows, a bar resonator is used. The application is not, however limited to resonant beams having rectangular cross sections.

Below, embodiments of MEMS resonator devices are described with optimal support anchoring for providing frequency and electromechanical stability and high Q-factor. However, the invention is not limited to a specific type of a MEMS resonator device, and can be used in its entity to any resonating structure.

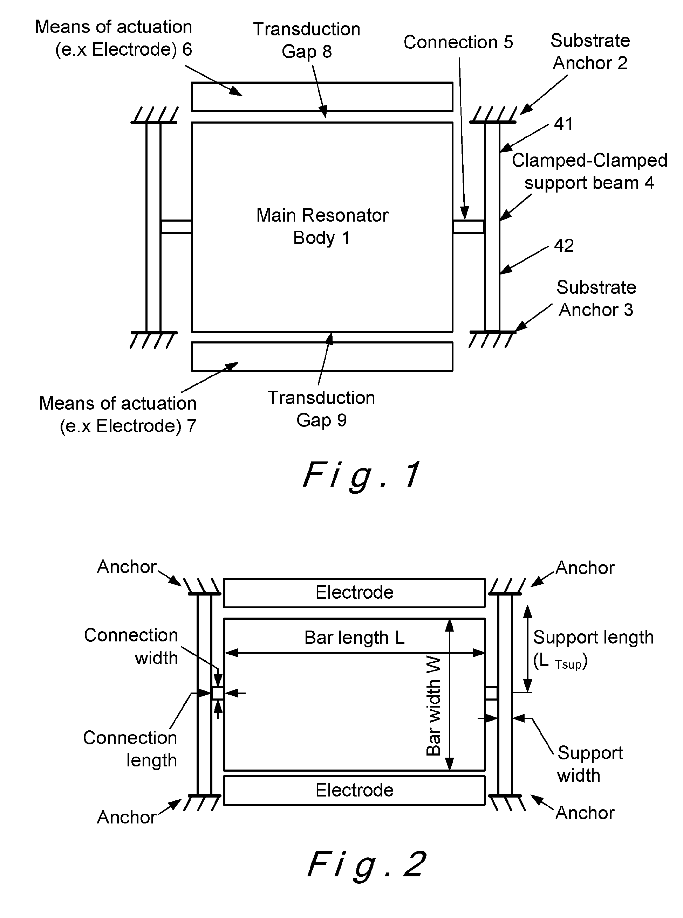

The MEMS resonator device shown in Fig 1 comprises a main resonance body 1 of any shape (e.g. rectangular, square, circular, parallelepiped, cube, etc), at least one means of actuation 6, 7 (e.g. electrode, magnetic) placed at close proximity, i.e. at a transduction gap 8, 9, to the main resonator body 1 and at least one T-shape support 4 for anchoring the main resonator body to the substrate.

The T-shaped support or T-support further comprises a clamped-clamped beam (further in the text "support" is also used) comprising two legs 41, 42 attached by means of anchors 2, 3 to the substrate, and a common, preferably central connection 5 to the main resonant body 1.

The MEMS resonator device or structure is configured to resonate at least in a predetermined mode, for example a breathing mode. The main resonator body resonates at a resonance frequency ($f_{res}$) related to its natural response. The length of the clamped-clamped beams or support is chosen to be in relation to the flexural wavelength (type of wavelength dependent on most important stress component to support) for providing frequency stability and high Q factor. The T-support design utilizing a rigid clamped-clamped support provides electromechanical stability in the direction of actuation. More in particular, the length $L_{Tsup}$ of each leg 41, 42 of the beam is chosen as a multiple of half the flexural wavelength plus an offset term.

The present disclosure is further exemplified by means of a bar-type bulk acoustic (BAW) resonator device configured to vibrate along its width in an extensional mode (breathing).

The BAW resonator comprises a bar, which acts as the main resonance body of the resonator, and two electrodes (actuation means) on either side of the main resonance body (bar).

The main body (bar) and electrodes have been designed as right parallelepipeds suspended in free space by means of supports, which anchor the MEMS resonator to the substrate. The anchoring supports are T-shaped or T-support as in Figure 2. The T-shaped or T-support further comprises a clamped-clamped support beam placed parallel to the resonator and connected to the resonator body at the symmetry line with a short, narrow connection.

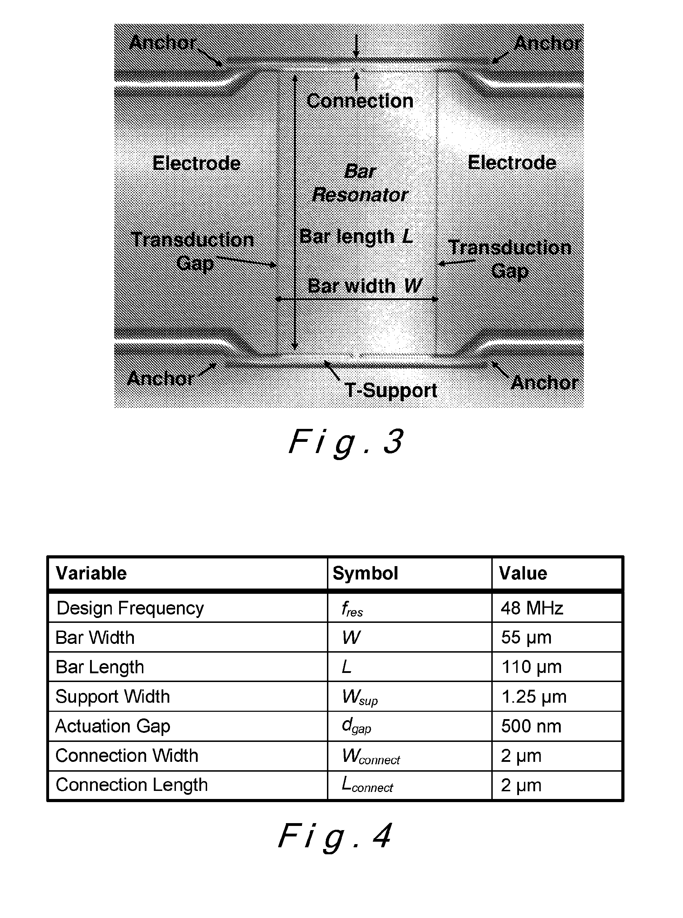

Figure 3 shows a SEM image of such a bar-type resonator with T-supports as realized in a poly-SiGe MEMS platform. The bar vibrates along its width in an extensional mode. A bar targeting a resonance frequency $f_{res}$ is designed with a bar width W close to $\lambda_{long}/2$, where $\lambda_{long}$ is the acoustic longitudinal wavelength at $f_{res}$. The resonance frequency, for the first width extensional mode, is approximately given by:

$$f_{res} \approx \frac{1}{2W}\sqrt{\frac{E}{\rho}} \tag{1}$$

where E and p denote the Young's modulus and specific mass of the resonator material, respectively. In this work an E of 120 GPa, p of 4577 kg/m3 and W of 55 $\mu$m result in a resonance frequency of 48MHz. The other design parameters are presented in Figure 4. The bar resonator is electro-statically actuated via two electrodes separated from the resonator by transduction gaps (500 nm in this work), e.g., as shown in Fig. 2. The device can either be used in a two-port configuration using one electrode to excite and the other to detect the signal, or in a one-port configuration in which case the device is excited and detected by the same electrodes (connected in parallel).

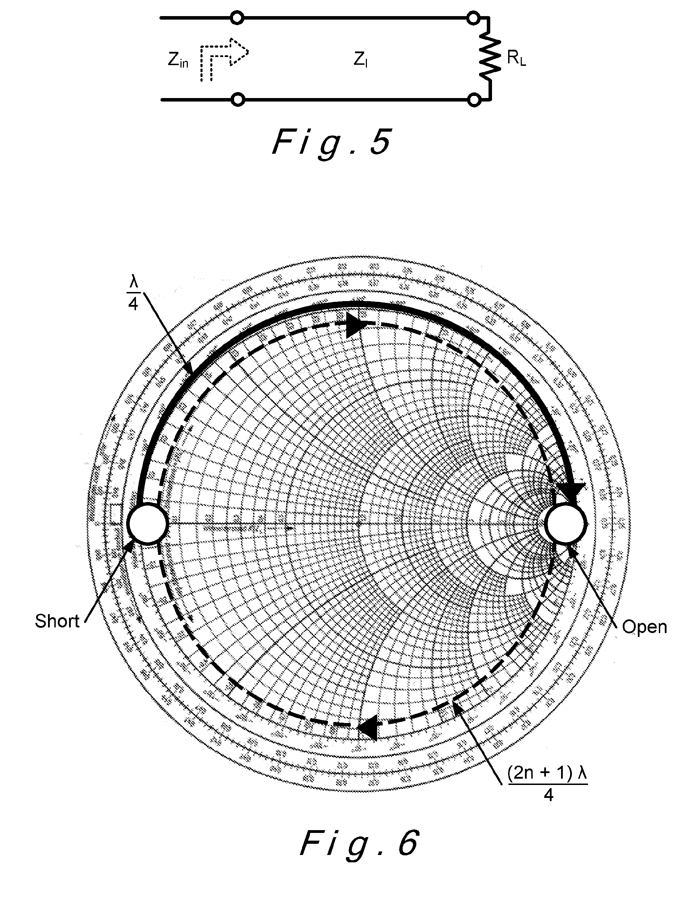

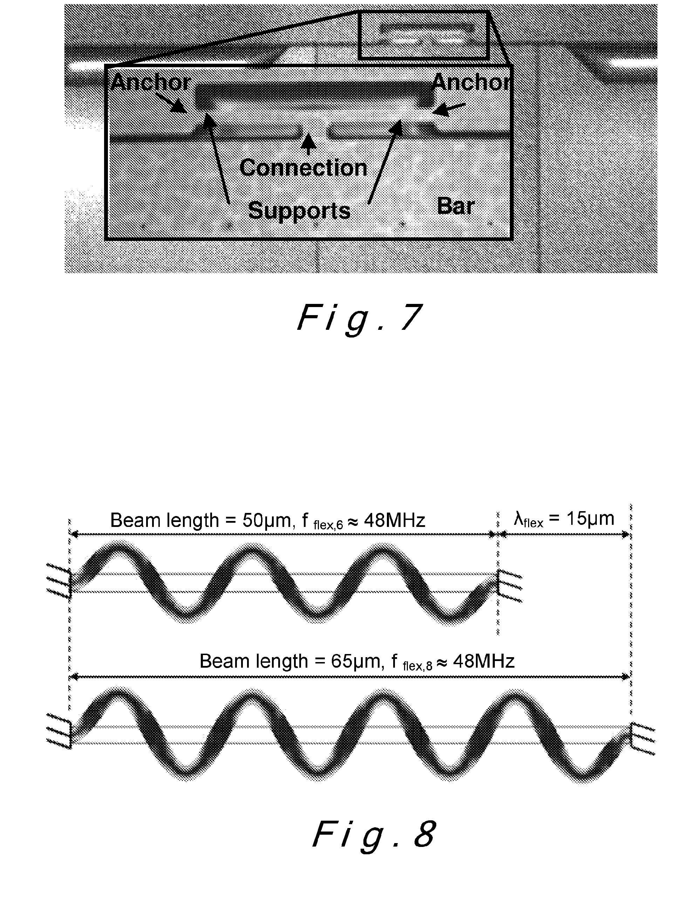

The T-type support (Fig. 2) comprises a support placed parallel to the side of the resonator connecting to the resonator at the symmetry line with a short, narrow connection 5. Figure 7 contains SEM images of a manufactured resonator with a T-support. To determine the optimal length of the support we refer to the analogy with the quarter-wave ($\lambda/4$) transformer concept known from RF theory. The impedance transformation from a transmission line with length "$\lambda/4$" (see Fig. 5) is given by:

$$Z_{in} = \frac{Z_1^2}{R_L} \qquad\qquad (2)$$

where the impedance $Z_{in}$ is the (acoustic) impedance seen by the resonator looking into the support, $Z_1$ is the characteristic acoustic impedance of the support beam (modeled as an acoustic transmission line) and $R_L$ is the acoustic impedance seen at the anchor. Since the anchoring provides an acoustic energy path to the substrate we can see $R_L$ as a type of acoustic short which absorbs all acoustic energy. If $R_L = 0$, the quarter wave transforms the impedance seen at the resonator to an open (see Fig. 6), effectively confining the acoustic energy to the resonant body. At first sight it seems that the impedance $Z_1$ is unimportant, however since $R_L$ is not a perfect short we need to maximize $Z_{in}$ by choosing the support width to be as narrow as possible in order to maximize the acoustic impedance $Z_1$. The $\lambda/4$ transformer technique described can again be applied for the T-type support to obtain an optimum support length $L_{Tsup,opt}$ to minimize energy losses to the anchors, with $L_{Tsup,opt}$ given by:

$$L_{Tsup,opt} \approx \frac{2i\lambda_{flex}}{4} + \frac{L_{cl-cl,1}}{2}, \qquad i = 0,1,2,3... \qquad (3)$$

where the flexural wavelength $\lambda_{flex}$ (see eq. (5) below) is used since the most important stress component is now perpendicular to the support.

Because a T-shape support anchoring further allows more flexibility in all other directions, the T-shape support legs can be designed with dimensions that enable alternative resonant modes, such as elongating, out of plane and side to side or tilting. So one can imagine that for a fixed support length, a resonant mode can be selected accordingly, thereby obtaining a MEMS resonator having a high (optimal) Q factor.

$L_{cl-cl,1}$ is the length of a clamped-clamped beam with first flexural resonance frequency equal to fres, approximated by:

$$L_{cl-cl,1} \approx \sqrt{\frac{1.028W_{sup}\sqrt{E/\rho}}{f_{res}}} \qquad (4)$$

For a given clamped-clamped beam, the flexural wavelength $\lambda_{flex}$ is given by:

$$\lambda_{flex} = \lim_{n\to\infty} \left(L_{(n+2)} - L_n\right) \qquad (5)$$

where $L_{(n+2)}$ and $L_n$ are the lengths of beams with respectively (n+2)th and nth flexural harmonics occurring at the frequency fres. The limit of n is taken so as to minimize the effect of the (clamped edge) anchoring. Figure 8 shows how eq. (4) is used together with FEM results to obtain $\lambda_{flex}$=15μm for the design parameters in Table 1. We can compute $\lambda_{flex}$ with eq. (5), after which $L_{Tsup,opt}$ is obtained from eq. (3).

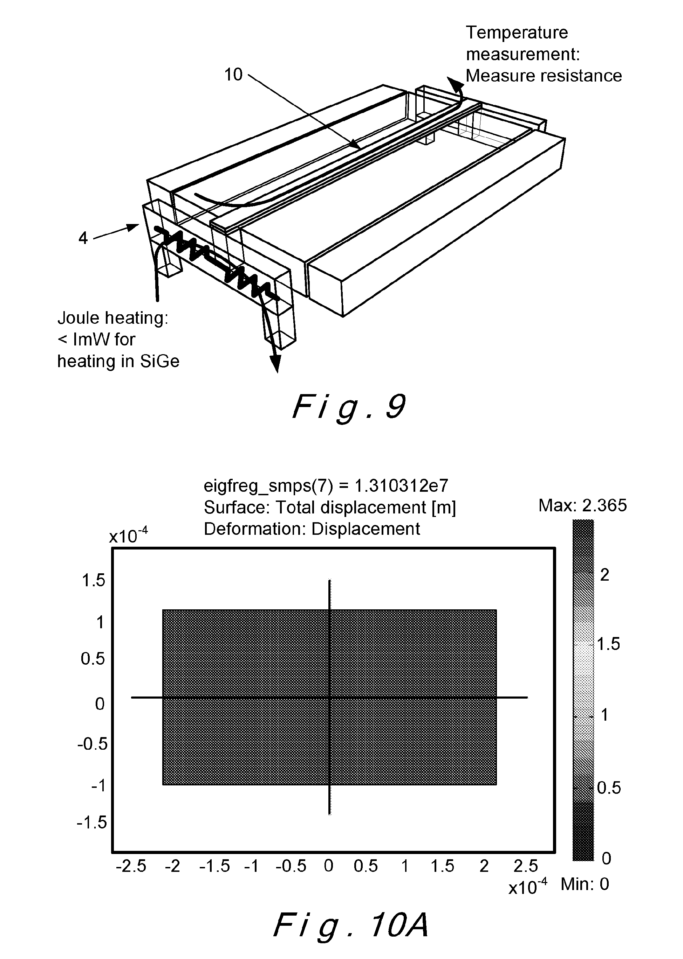

In the embodiment shown in figure 9, the T-shaped support 4 is used for heating the MEMS resonator main body to the operating temperature. Current is supplied to the T-shaped support for achieving Joules heating. In order to control the current, the temperature of the main body is measured by means of a resistance 10 on top of the resonator body. Using this principle in combination with the acoustically long leg design, power consumption for heating can be reduced to below 1 mW.

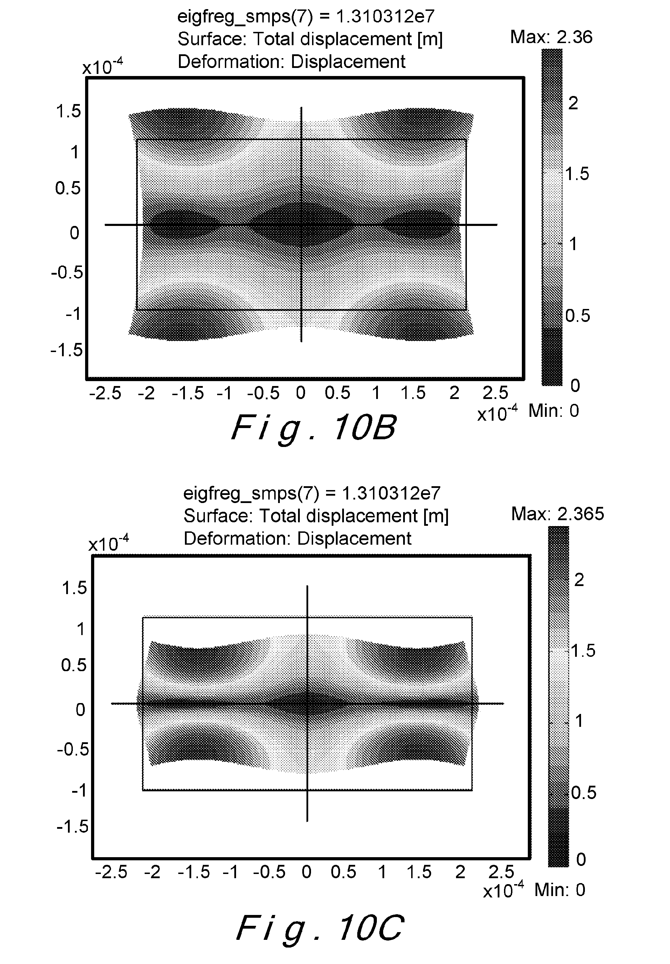

Figure 10A-C shows displacement of an oscillating MEMS resonator suitable for use in embodiments according to the invention. The resonator oscillates in a breathing mode, i.e. the body expands and contracts. Figure 10A shows the main body in its original, flat shape, i.e. no displacement. Figure 10B shows the displacement at the point of maximum expansion of the oscillation of the main body: there is substantially no displacement at the longitudinal (central) axis of the body, and maximal displacement along the longitudinal edges of the body. Figure 10C shows the displacement at the point of maximum contraction of the oscillation of the main body: there is likewise substantially no displacement at the longitudinal axis of the body, and maximal displacement along the longitudinal edges of the body. This shows that this longitudinal axis is the best place to connect the supports for this oscillator in this breathing mode.

**Claims**

1. MEMS resonator comprising:

   a substrate;
   a resonator body (1) suspended above the substrate by means of clamped-clamped beams (4), each beam comprising two support legs (41, 42) with a common connection (5) to the resonator body, the resonator body (1) being adapted for resonating at an operating frequency ($f_{res}$);
   excitation means (6, 7) for exciting the resonator body into a vibration at the operating frequency *($f_{res}$)*;
   **characterised in that**
   each beam is adapted for oscillating in a flexural mode at a given flexural wavelength as a result of said vibration of said resonator body at said operating frequency ($f_{res}$), each leg being acoustically long with respect to said flexural wavelength of the beam.

2. MEMS resonator according to claim 1, wherein each leg (41, 42) has a length ($L_{Tsup,opt}$) equal to a predetermined multiple of said flexural wavelength divided by two, plus a predetermined offset, the predetermined multiple being selected in view of optimising thermal resistance of the leg and the quality factor of the resonator, and the predetermined offset being selected in view of optimising the quality factor of the resonator.

3. MEMS resonator according to claim 2, wherein said predetermined offset is substantially equal to half the length ($L_{cl-cl,1}$) of a clamped-clamped beam with first flexural resonance frequency equal to the operating frequency *($f_{res}$)*.

4. MEMS resonator according to claim 3, wherein said length ($L_{cl-cl,1}$) of the clamped-clamped beam with first flexural resonance frequency equal to the operating frequency *($f_{res}$)* is approximated by

$$L_{cl-cl,1} \approx \sqrt{\frac{1.028 W_{sup}\sqrt{E/\rho}}{f_{res}}}$$

   wherein $W_{sup}$ is the width of the support legs and E and p respectively denote the Young's modulus and specific mass of the resonator material.

5. MEMS resonator according to any one of the previous claims, wherein said resonator body (1) is adapted for resonating in a breathing mode which has a symmetry axis where displacement is minimal and wherein the common connections (5) of the clamped-clamped beams (4) are located at said symmetry axis.

6. MEMS resonator according to any one of the previous claims, wherein said clamped-clamped beams (4) are T-shaped, centrally connected to the resonator body (1).

7. MEMS resonator according to any one of the previous claims, wherein said clamped-clamped beams are angled.

8. MEMS resonator according to any one of the previous claims, wherein said clamped-clamped beams have a rigid direction, said excitation means being located for exciting the resonator body in the rigid direction of said beams.

9. MEMS resonator according to any one of the previous claims, wherein at least one of said beams forms a heating resistance for heating the resonator through Joules heating.

Means of actuation
(e.x Electrode) 6

Transduction
Gap 8

Connection 5

Substrate
Anchor 2

41

Clamped-Clamped
support beam 4

Main Resonator
Body 1

42

Substrate
Anchor 3

Means of actuation
(e.x Electrode) 7

Transduction
Gap 9

*Fig.1*

Anchor

Electrode

Anchor

Connection
width

Bar length L

Support length
(L Tsup)

Connection
length

Bar width W

Electrode

Support
width

Anchor

Anchor

*Fig.2*

*Fig.3*

| Variable | Symbol | Value |
|---|---|---|
| Design Frequency | $f_{res}$ | 48 MHz |
| Bar Width | $W$ | 55 μm |
| Bar Length | $L$ | 110 μm |
| Support Width | $W_{sup}$ | 1.25 μm |
| Actuation Gap | $d_{gap}$ | 500 nm |
| Connection Width | $W_{connect}$ | 2 μm |
| Connection Length | $L_{connect}$ | 2 μm |

*Fig.4*

$Fig.5$

$\frac{\lambda}{4}$

Short

Open

$\frac{(2n + 1)\,\lambda}{4}$

$Fig.6$

Fig. 7

Beam length = 50μm, f $_{flex,6}$ ≈ 48MHz    λ$_{flex}$ = 15μm

Beam length = 65μm, f $_{flex,8}$ ≈ 48MHz

Fig. 8

Temperature
measurement:
Measure resistance

10

4

Joule heating:
< ImW for
heating in SiGe

*Fig. 9*

eigfreg_smps(7) = 1.310312e7
Surface: Total displacement [m]
Deformation: Displacement

Max: 2.365

x10⁻⁴

Min: 0
x10⁻⁴

*Fig. 10A*

eigfreg_smps(7) = 1.310312e7
Surface: Total displacement [m]
Deformation: Displacement
Max: 2.36

*Fig. 10B*

eigfreg_smps(7) = 1.310312e7
Surface: Total displacement [m]
Deformation: Displacement
Max: 2.365

*Fig. 10C*

Europäisches
Patentamt

European
Patent Office

Office européen
des brevets

# EUROPEAN SEARCH REPORT

Application Number

EP 11 16 8324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FR 2 946 479 A1 (COMMISSARIAT ENERGIE ATOMIQUE [FR]) 10 December 2010 (2010-12-10) | 1-8 | INV. H03H9/02 |
| Y | * abstract * * page 15, line 14 - page 16, line 30 * * page 18, line 15 - page 20, line 5; figures 2, 4 * | 9 | |
| Y | US 2007/296527 A1 (LUTZ MARKUS [US] ET AL) 27 December 2007 (2007-12-27) * paragraphs [0010] - [0011], [0097] - [0103] * | 9 | |
| X | KHINE L ET AL: "12.9MHz Lame-Mode Differential SOI Bulk Resonators", SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10 June 2007 (2007-06-10), pages 1753-1756, XP031216392, ISBN: 978-1-4244-0841-2 * the whole document * | 1,5 | |
| X | KHINE L ET AL: "7MHZ length-extensional soi resonators with T-shaped anchors", SOLID-STATE SENSORS, ACTUATORS AND MICROSYSTEMS CONFERENCE, 2009. TRANSDUCERS 2009. INTERNATIONAL, IEEE, PISCATAWAY, NJ, USA, 21 June 2009 (2009-06-21), pages 1441-1444, XP031545725, ISBN: 978-1-4244-4190-7 * figures 7-9 * | 1 | TECHNICAL FIELDS SEARCHED (IPC) H03H |
| X | US 2009/153267 A1 (LUTZ MARKUS [US] ET AL) 18 June 2009 (2009-06-18) * figures 2D-2H * | 1 | |

-/--

The present search report has been drawn up for all claims

| Place of search | Date of completion of the search | Examiner |
|---|---|---|
| The Hague | 11 January 2012 | De La Pinta, Luis |

EPO FORM 1503 03.82 (P04C01)

Europäisches
Patentamt

European
Patent Office

Office européen
des brevets

**EUROPEAN SEARCH REPORT**

Application Number

EP 11 16 8324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/314969 A1 (GAIDARZHY ALEXEI [US] ET AL) 16 December 2010 (2010-12-16) * figures * | 1 | |
| X | US 2007/052498 A1 (PAN ZHIYU [US] ET AL) 8 March 2007 (2007-03-08) * paragraphs [0061] - [0063], [0068]; figures 4C, 4D, 7-8 * | 1 | |

TECHNICAL FIELDS
SEARCHED      (IPC)

The present search report has been drawn up for all claims

| Place of search | Date of completion of the search | Examiner |
|---|---|---|
| The Hague | 11 January 2012 | De La Pinta, Luis |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

# EP 2 479 891 A1

## ANNEX TO THE EUROPEAN SEARCH REPORT
## ON EUROPEAN PATENT APPLICATION NO.

EP 11 16 8324

This annex lists the patent family members relating to the patent documents cited in the above-mentioned European search report.
The members are as contained in the European Patent Office EDP file on
The European Patent Office is in no way liable for these particulars which are merely given for the purpose of information.

11-01-2012

| Patent document cited in search report | | Publication date | Patent family member(s) | | Publication date |
|---|---|---|---|---|---|
| FR 2946479 | A1 | 10-12-2010 | FR | 2946479 A1 | 10-12-2010 |
| | | | WO | 2010142643 A1 | 16-12-2010 |
| US 2007296527 | A1 | 27-12-2007 | NONE | | |
| US 2009153267 | A1 | 18-06-2009 | CN | 101946400 A | 12-01-2011 |
| | | | EP | 2235821 A1 | 06-10-2010 |
| | | | JP | 2011507455 A | 03-03-2011 |
| | | | TW | 200943708 A | 16-10-2009 |
| | | | US | 2009153267 A1 | 18-06-2009 |
| | | | US | 2011018655 A1 | 27-01-2011 |
| | | | WO | 2009079188 A1 | 25-06-2009 |
| US 2010314969 | A1 | 16-12-2010 | US | 2010314969 A1 | 16-12-2010 |
| | | | WO | 2010110918 A1 | 30-09-2010 |
| US 2007052498 | A1 | 08-03-2007 | EP | 1925075 A1 | 28-05-2008 |
| | | | US | 2007052498 A1 | 08-03-2007 |
| | | | WO | 2007030268 A1 | 15-03-2007 |

EPO FORM P0459

For more details about this annex : see Official Journal of the European Patent Office, No. 12/82

16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **W.-T., HSU ; J. R. CLARK et al.** Mechanically temperature-compensated flexural-mode micromechanical resonators. *Technical Digest International Electron Devices Meeting,* 2000, 399-402